(19) Europäisches Patentamt
European Patent Office
Office européen des brevets

(11) **EP 2 437 314 A2**

(12) **EUROPEAN PATENT APPLICATION**

(43) Date of publication:
**04.04.2012 Bulletin 2012/14**

(51) Int Cl.:
***H01L 31/055*** (2006.01)

(21) Application number: **11182365.4**

(22) Date of filing: **22.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.09.2010 US 894916**

(71) Applicant: **General Electric Company Schenectady, NY 12345 (US)**

(72) Inventors:
• **Tsakalakos, Loucas**
  **Niskayuna, NY New York 12309 (US)**
• **Srivastava, Alok Mani**
  **Niskayuna, NY New York 12309 (US)**
• **Korevaar, Bastiaan Arie**
  **Niskayuna, NY New York 12309 (US)**
• **Stern Gonzalez, Omar Ivan**
  **Niskayuna, NY New York 12309 (US)**
• **Xi, Yangang Andrew**
  **Niskayuna, NY New York 12309 (US)**

(74) Representative: **Szary, Anne Catherine GE International Inc. Global Patent Operation - Europe 15 John Adam Street London WC2N 6LU (GB)**

(54) **Photovoltaic devices**

(57) A photovoltaic device (200) having a down-converting layer (214) disposed on the device is presented. The down-converting layer (214) has a graded refractive index, wherein a value of refractive index at a first surface of the down-converting layer varies from a value of refractive index at a second surface of the layer. A photovoltaic module having a plurality of such photovoltaic devices is also presented.

FIG. 9A

## Description

BACKGROUND

This invention generally relates to photovoltaic devices with improved efficiency by enhanced down-conversion of photons. More particularly, the invention relates at least in part to a down-converting layer for improving energy conversion in photovoltaic devices.

One of the main focuses in the field of photovoltaic devices is the improvement of energy conversion efficiency (from electromagnetic energy to electric energy or vice versa). The devices often suffer reduced performance due to loss of light. Therefore, research in optical designs of these devices includes light collection and trapping, spectrally matched absorption, and up/down light energy conversion.

Typically, the photovoltaic devices suffer loss of efficiency due to a thermalization mechanism in which carriers generated by high-energy photons are lost as phonons in the crystal. The absorption of incident photons with energies greater than the threshold energy for the absorption leads to the generation of typically only one electron-hole pair per absorbed photon, regardless of the photon energy. The excess energy of an incident photon above the threshold energy is wasted during the thermalization of the generated electron-hole pairs. Certain cell designs, employing a heterojunction window layer, lose high-energy photons due to parasitic absorption in the window layer. It is therefore desirable to convert these high-energy photons (short wavelength) to lower energy photons (long wavelength) that can be effectively absorbed in an absorber photovoltaic layer, and converted to collectable charge carriers.

One well-known method to overcome loss of light and related loss mechanisms involves "down-conversion" of high electromagnetic energy from a shorter wavelength to a longer wavelength. Because the absorption of high-energy photons in undesired regions/layers of optoelectronic devices must be avoided, a down-converting layer may be disposed on a surface of the device, exposed to electromagnetic radiation.

Therefore, it would be desirable to produce improved photovoltaic devices having down-converting properties, in order to meet various performance requirements.

BRIEF DESCRIPTION OF THE INVENTION

One embodiment of the invention is a photovoltaic device including a down-converting layer disposed on the device. The down-converting layer have a graded refractive index, wherein a value of refractive index at a first surface of the down-converting layer varies to a value of refractive index at a second surface of the layer.

Another embodiment is a photovoltaic module having a plurality of photovoltaic devices as described above.

DRAWINGS

These and other features, aspects, and advantages of the present invention will become better understood when the following detailed description is read with reference to the accompanying drawings, wherein:

FIG. 1 is an energy level diagram for a material related to one embodiment of the present invention;

FIG. 2 is a schematic of a composite down-converting layer, according to one embodiment of the present invention;

FIG. 3 is a schematic of a composite down-converting layer, according to another embodiment of the present invention;

FIG. 4 is a schematic of a composite down-converting layer, according to yet another embodiment of the present invention;

FIG. 5 is a schematic of a composite down-converting layer, according to yet another embodiment of the present invention;

FIG. 6 is a schematic of a composite down-converting layer, according to yet another embodiment of the present invention;

FIG. 7 is a schematic of a photovoltaic device, according to one embodiment of the present invention;

FIG. 8 is a schematic of a photovoltaic device, according to another embodiment of the present invention;

FIG. 9A is a schematic of a photovoltaic device, according to an exemplary embodiment of the present invention;

FIG. 9B is a schematic of a photovoltaic device, according to an exemplary embodiment of the present invention;

FIG. 9C is a schematic of a photovoltaic device, according to an exemplary embodiment of the present invention;

FIG. 10 shows a micrograph of a composite down-converting layer, according to an exemplary embodiment of the present invention;

FIG. 11 is a graph showing improved efficiency of a CdTe PV module, according to an exemplary embodiment of the present invention.

## DETAILED DESCRIPTION

As discussed in detail below, some of the embodiments of the present invention provide a layer or a coating for optical surfaces to improve energy conversion. These embodiments advantageously reduce loss of light due to parasitic absorption and thermalization mechanisms. The embodiments of the present invention describe a photovoltaic device with improved efficiency having such a layer disposed on a surface of the photovoltaic device.

Approximating language, as used herein throughout the specification and claims, may be applied to modify any quantitative representation that could permissibly vary without resulting in a change in the basic function to which it is related. Accordingly, a value modified by a term or terms, such as "about", is not limited to the precise value specified. In some instances, the approximating language may correspond to the precision of an instrument for measuring the value.

In the following specification and the claims, the singular forms "a", "an" and "the" include plural referents unless the context clearly dictates otherwise.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances the event or capacity cannot occur — this distinction is captured by the terms "may" and "may be".

The term "transparent", as used herein, means that a layer of a material allow the passage of a substantial portion of incident solar radiation. The substantial portion may be at least about 80% of the incident solar radiation.

As discussed in detail below, some embodiments of the invention are directed to improved photovoltaic (PV) device designs. A down-converting layer having a graded refractive index is disposed on the device. A value of refractive index at a first surface of the layer varies from a value of refractive index at a second surface of the layer.

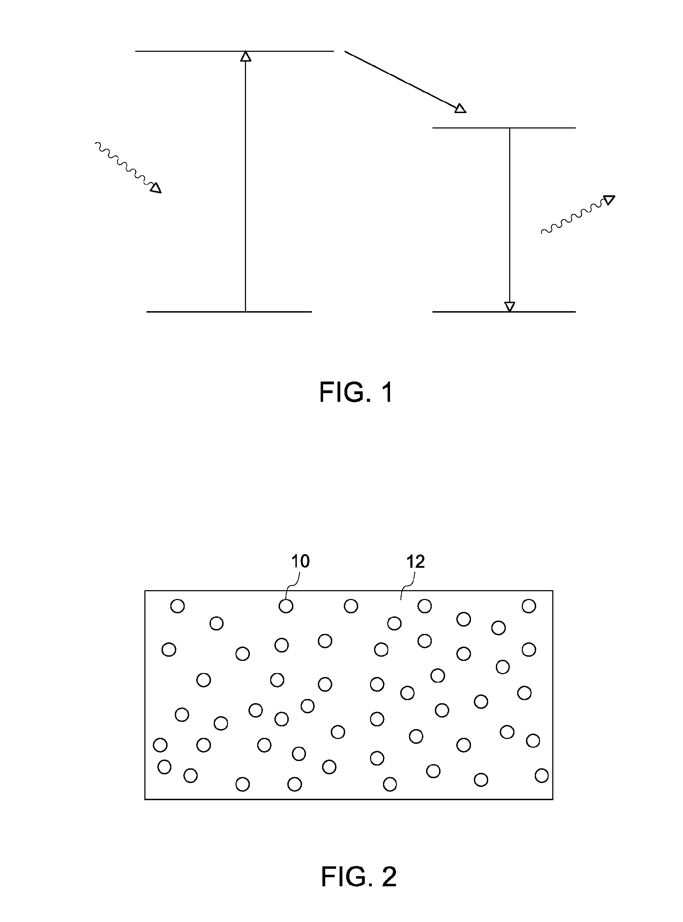

"Down-conversion" represents a method for the generation of one or multiple electron—hole pairs, per incident high-energy photon, and can be used to reduce the thermalization losses. It is a material property that can be achieved if the material contains states or bands of intermediate energies. Incident high-energy photons can be transformed by the material into one or multiple lower energy photons. In a particular embodiment, the material is capable of emitting one photon per absorbed photon. FIG. 1 shows such energy levels of atoms in a down-converting material, and illustrates the process of down-conversion in which one photon of lower energy is produced. In some other embodiments, the material may emit more than one photon on absorption of one photon. As used herein "down-converting layer" may be a single layer, or may include multiple sub-layers.

According to an embodiment of the invention, the down-converting layer comprises a phosphor material. Typically, such down-converting material contains a host material activated by a dopant (activator). A host material can be described as a transparent host lattice. A dopant adds desired energy levels at which incoming radiation is absorbed, such as an external photon, and a generated internal photon is preferentially emitted, based on the underlying absorber properties. Therefore, the down-converting material, at the basic level, contains an absorber and an emitter.

A variety of dopants may be used, based on the desired energy level of the emitted photon. In one embodiment, dopant ions that may be used for 1 to 1 down-conversion include lanthanide ions, transition metal ions and rare-earth ions. Examples of suitable dopant ions include $Ce^{3+}$, $Eu^{2+}$, $Sm^{2+}$, $Cr^{3+}$, $Mn^{2+}$ and $Mn^{4+}$. In addition, sensitizers may be doped into the host materials along with the dopants. Sensitizers are useful if the dopant ions cannot be excited, for example, because of forbidden transitions. The exciting energy is absorbed by the sensitizers and subsequently transferred to the dopant ions. For example, transition metal ions may be sensitized by the lanthanide ions.

Although FIG. 1 shows the emission of one photon as a result of absorption of a higher energy photon, it is possible to produce multiple photons per absorbed photon. In some embodiments, more than one photon is emitted per absorbed photon. This type of down-conversion is usually referred to as "quantum-cutting" or "quantum-splitting". For example, a single dopant ion such as $Pr^{3+}$, $Tm^{3+}$ or $Gd^{3+}$, or a combination of two ions, such as the $Gd^{3+}$-$Eu^{3+}$ dual ion, may be able to generate two low energy photons for every incident high-energy photon. Other combinations include $Yb^{3+}$-$Tb^{3+}$ and $Yb^{3+}$-$Pr^{3+}$ dual ions.

Suitable examples of phosphor material may include halides, oxides and phosphates. Suitable examples of fluorides include, but are not limited to, samarium-doped $BaAlF_5$, samarium-doped $(Ba, Sr, Ca)MgF_4$. Other examples include mixed halides such as samarium-doped $(Ca, Sr, Ba)XX''$ (X=F; X''=Cl, Br, I). Non-limiting examples of other suitable phosphors may include samarium-doped strontium borate ($SrB_4O_7$:$Sm^{2+}$), samarium-doped (Sr, Ca, Ba)$BPO_5$ and europium-doped (Sr, Ca)$SiO_4$.

Other down-converting materials may include organic materials. For example, an organic down-converting material may include an organic dye, such as BASF LUMOGEN dye. Furthermore, a hybrid organic-inorganic dye may also be used for down-conversion. In another embodiment the down converting material comprises a quantum dot, such as a core-shell giant quantum dot system.

The optical properties of the down-converting layer can be determined, in large part, by its material composition, particle size of down-converting material, thickness of the layer etc. By controlling the amount, particle size, and refractive index of the down-converting material, the refractive index and conversion properties of the down-converting layer may be tailored to minimize energy losses.

The down-converting material may absorb radiation of a particular wavelength, or a particular range of wavelengths, while not scattering the radiation. The material may absorb radiation from UV, to visible, to near infrared, to infrared and converts the absorbed radiation to usable radiation. The term "usable radiation" as used herein, refers to photons of a particular wavelength, or a particular range of wavelengths that takes part in energy conversion with high internal and external quantum efficiency. That is, the probability of collecting an electron-hole pair in that spectral range is high, usually greater than about 60%, and often greater than about 80%. Thus, the down-converting material emits such photons that can be absorbed by a semiconductor layer of the device to produce an electron-hole pair. In a certain embodiment for solar energy conversion, the material absorbs radiation with wavelength below about 525 nm, and produces radiation with wavelength longer than 550 nm. Moreover, the excitation and absorption properties of the down-converting layer, as well as the emission spectrum, are designed to enhance external quantum efficiency (EQE) of the PV device.

In addition to down-conversion properties, the material exhibits a refractive index value that should typically match well with refractive indices of adjacent mediums. This configuration advantageously provides reduced reflection at interfaces because of improved matching of refractive indices. Thus, the down-converting layer described herein benefits the photovoltaic device in two ways: (1) reduces absorption losses and (2) reduces reflection losses, and thus improves over all energy conversion.

According to an embodiment of the present invention, the down-converting layer may have a graded refractive index. The graded refractive index may be defined as a variation in the refractive index as a function of position in a selected direction, typically a direction perpendicular to a substrate supporting the layer. A value of refractive index at a first surface of the layer varies from a value of refractive index at a second surface of the layer. The variation in refractive index may be continuous in the selected direction or may occur in a series of discrete steps.

The gradient of refractive index can be achieved by compositional variations. The graded composition provides a graded refractive index to the layer. The "graded composition" as defined herein refers to a gradual variation in the composition of the down-converting material in one direction, although the gradation may not always be constant. In this manner, the excitation and emission profile of the layer can be broadened, which will have beneficial effect of providing a broad coverage of wavelength ranges for the overall down-converting layer. In one embodiment, the down-converting layer is a single layer. In another embodiment, the down-converting layer includes more than one sub-layer. Multiple sub-layers of different refractive indices may be deposited, one over another, to attain the desired grading.

In some embodiments, the particles 10 of the down-converting material may be dispersed or embedded in a transparent matrix 12, as illustrated in FIG. 2. As used herein, the term "embedded" is used to indicate that the down-converting particles 10 are at least substantially enclosed within the matrix 12. The particles 10 are dispersed in such a manner that minimal agglomeration between the particles 10 is achieved. The refractive index of the matrix 12 may be higher than that of the down-converting material in some embodiments, and lower than that of the down-converting material in other embodiments. Such down-converting layer may also be referred to as "composite down-converting layer" and exhibit an "effective refractive index" which results from the combination of refraction due to particles and refraction due to the matrix (discussed in detail below). The effective refractive index of the composite down-converting layer depends on various parameters, such as refractive index of the matrix, refractive index of the down-converting material, and particle size of down-converting particles, among others.

In general, the refractive index of a medium is defined as the ratio of the velocity of light in a vacuum to that of the medium. In a real material, the refractive index can be defined as $n = n' + ik$, where $n'$ is the refractive index indicating the phase speed, while $k$ is the extinction coefficient, which indicates absorption loss when an electromagnetic wave propagates through the material. Both $n$ and $k$ are dependent on the wavelength.

"Effective refractive index", as used herein, refers to refractive index of the composite down-converting layer having down-converting particles embedded in a matrix. The effective refractive index, as defined herein, is used to determine the phase lag and attenuation of the coherent wave as electromagnetic radiation propagates through the layer. The parameters such as size, local volume fraction or area fraction, down-converting material fraction, matrix fraction and material refractive index, determine the effective refractive index of the layer. The effective refractive index of the down-converting layer may be given as:

$$n_{eff} = (1-\alpha)n_m + \alpha n_p$$

where $n_m$ and $n_p$ represent refractive indices of the matrix and the down-converting particles, and $\alpha$ represents volume fraction of the down-converting particles in the matrix.

As indicated above, the refractive index of a material or medium may vary with wavelength. This effect is typically known as dispersion. In the case of a composite down-converting layer, the refractive indices of the down-converting material particles 10 and the matrix 12 may vary differently with wavelength. By tailoring the difference in respective refractive indices ($\Delta n$) of the down-converting material and the matrix, absorption of the spectral radiation within the composite layer can be engineered. In some embodiments, the dispersion of refractive indices for the down-converting particles 10 and the matrix 12 are chosen such that the refractive indices are well matched in the long wavelength range (> about 550 nanometers) of the solar spectrum so that scattering is minimized for incoming radiation in that range. However, the dispersion in the lower wavelength region, specifically below about 525 nm, is chosen such that the refractive indices diverge such that photon-trapping in the composite layer can occur to improve absorption.

Thus, the down-converting material may contain particles of various shapes and sizes depending on refractive index of the constituents' materials, difference in refractive indices ($\Delta n$) and scattering effects. In other words, the size of particles is in part, a function of $\Delta n$. In some instances, nanosize particles of the down-converting material are desirable, especially for $\Delta n$ larger than about 0.05. As used herein, "nanosize" refers to average size of the down-converting particles in a range from about 1 nanometer to about 500 nanometers, and in some specific embodiments, from about 10 nanometers to about 100 nanometers. In some other instances, bigger particles may be used for $\Delta n$ less than about 0.05. In these instances, the average particle size ranges from about 0.5 micron to about 10 microns, and in specific embodiments, from about 1 micron to about 5 microns.

In some embodiments, the matrix 12 may include a non-conductive, non-crystalline material such as glass. Non-limiting examples of glasses may include soda-lime glass, alumino-silicate glass, boro-silicate glass, silica, and low-iron glass. In some embodiments, the matrix 12 may include a non-conductive crystalline material. Other suitable materials such as a dielectric material or a hybrid organic-inorganic material may also be used.

In some embodiments, the down-converting material particles 10 may be present in the matrix 12 in any amount (percentage) that is appropriate for the desired function. Suitably, the down-converting particles 10 may be present at a level of between about 0.001 % to about 60 % by volume, depending on the type of the matrix material and type of down-converting material. In some specific embodiments, the percentage (amount) may be in a range of from about 10 % to about 25 % by volume.

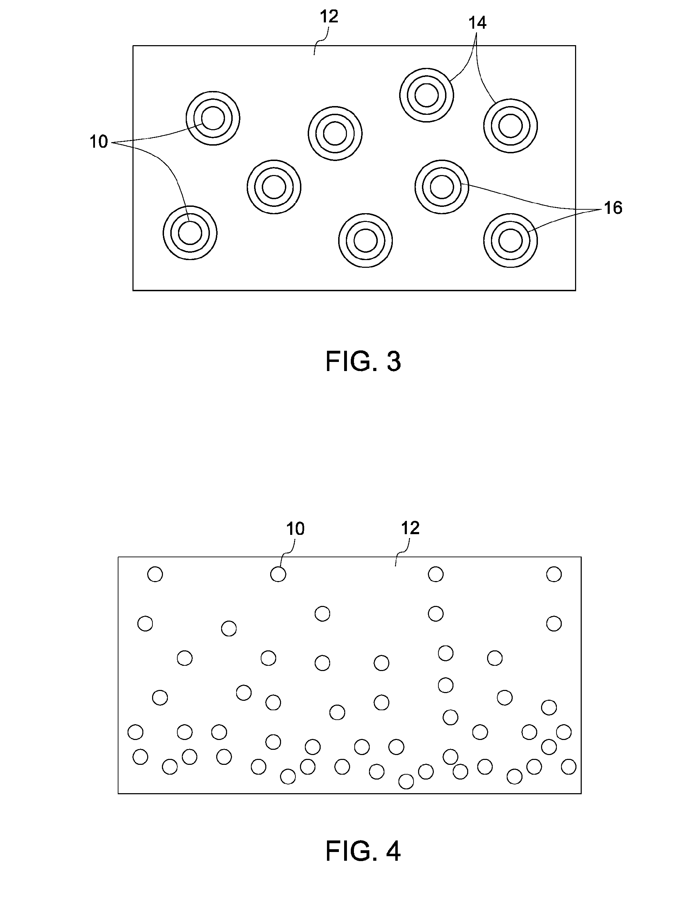

The down-converting materials may also contain additional layers on them, for the purposes of surface passivation or improved refractive index matching (e.g. a core-shell structure). FIG. 3 illustrates such an embodiment of core-shell structures 14 of down-converting particles 10 dispersed in the matrix 12. The particles 10 of down-converting material form the core, which are coated with one or more dielectric shell layers 16. The multiple shell layers 16 are configured such that they substantially match the refractive index of the matrix 12 on one side, and that of the phosphor particles 10 on the other. These shell layers 16 may allow for better optical coupling of incoming short wavelength radiation to the down-converting particles 10 so that scattering is reduced for the composite down-converting layer. The shell layers 16 may further allow for better out-coupling of down-converted long wavelength radiation into the matrix 12 of the composite layer.

In another embodiment, the down-converting particles 10 are coated with a thin layer of metal nanoparticles (not shown). These particles have strong plasmon resonance that helps to improve the emission efficiency (luminescent quantum efficiency) of down converted radiation from the down-converting particles 10. In some instances, the metal nanoparticles are placed in direct contact with the down-converting particles 10, and in some other instances, the metal nanoparticles are separated by a thin dielectric shell that is first coated on the down-converting particles. The thickness of the shell layers may be about 1 nanometer to about 10 nanometers. These coated particles are then mixed with a liquid precursor matrix solution, which is deposited and solidified to form the composited down-converting layer.

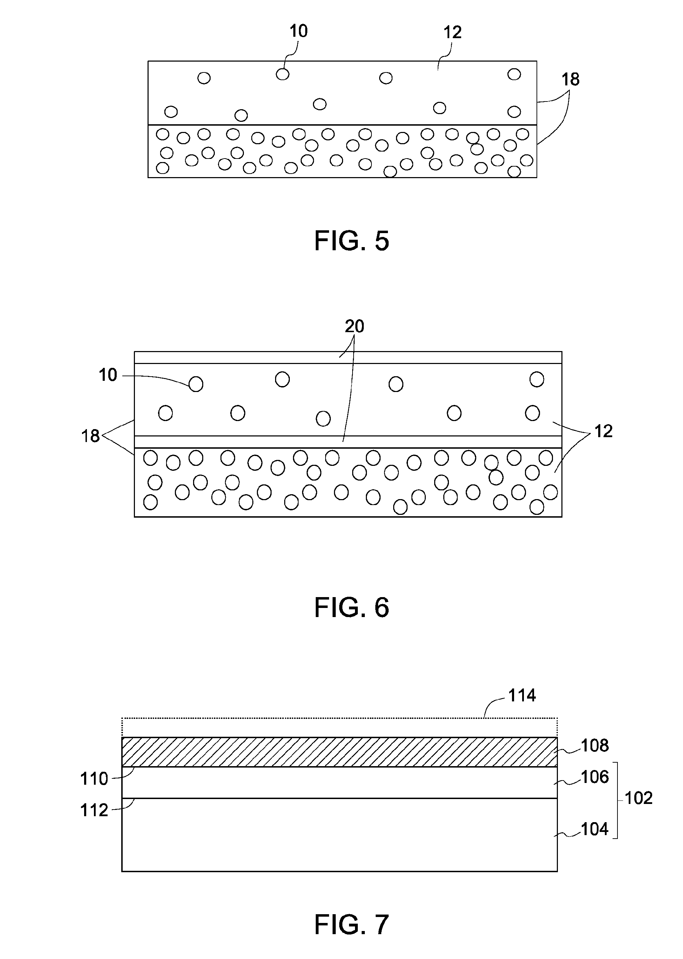

In certain instances, to achieve a refractive index gradient, the down-converting particles 10 form a density gradient from a lower region to an upper region within the matrix 12. This density gradient provides gradation in refractive index of the layer in one direction, although the gradation may not always be constant. In one embodiment, the down-converting layer is a single layer having density gradation as illustrated in FIG. 4. FIG. 5 illustrates another embodiment where the down-converting layer includes more than one sub-layer 18. Multiple sub-layers 18 of varying density of down-converting particles 10 may be deposited, one over another, to attain the desired refractive index grading. In some instances, sub-layers 18 of different refractive indices may be separated by dielectric layers 20 as illustrated in FIG. 6. Suitable dielectric materials include silicon oxide, silicon nitride, titanium oxide, hafnium oxide or combinations thereof. In some instances, the dielectric layers 20 may act as back reflectors that minimize reflectance of the photons emitted from the down-converting layer(s) back to a device.

Generally, the down-converting layer has a thickness greater than about 100 nanometers. In some embodiments, the thickness of the layer may be in a range of about 500 nanometers to about 1 micron. In case of multiple sub-layers, the thickness of each of the sub-layer may be in a range of about 500 nanometers to about 800 nanometers, in some instances. In some other embodiments, the down-converting layer has a thickness from about 1 micron to about 3000 microns, and in some specific embodiments from about 1 to about 100 microns.

A down-converting layer characterized by a graded index profile provides good matching of refractive index at the interfaces resulting in less reflection than may be achieved with a uniform refractive index. The refractive index of the layer may increase or decrease with position from a first surface towards a second surface. Furthermore, the variation of the refractive index may also depend on the position of the layer in the device so that the values of refractive indices at the first and the second surface substantially match with the respective adjacent layers or mediums.

The down-converting layer can be formed by a variety of techniques, such as physical vapor deposition, chemical deposition, sputtering, solution growth, and solution deposition. Other suitable techniques include dip-coating, spray-coating, spin-coating, slot-die coating, roller coating, gravure printing, ink-jet printing, screen printing, capillary printing, tape casting, flexo coating, extrusion coating, and combinations thereof.

The down-converting layer may be disposed or attached to a variety of photovoltaic devices. In one embodiment, the photovoltaic device includes a single junction or a multi-junction photovoltaic cell. Non-limiting examples of photovoltaic cells include an amorphous silicon cell, a crystalline silicon cell, a hybrid/heterojunction amorphous and crystalline silicon cell, a CdTe thin film cell, a micromorph tandem silicon thin film cell, a Cu(In, Ga,Al)(Se,S)$_2$ (also referred to as "CIGS") thin film cell, a copper-zinc-tin-sulfide (CZTS) thin film cell, a metal sulfide thin film cell, a metal phosphide thin film cell, a GaAs cell, a multiple-junction III-V-based solar cell, a dye-sensitized solar cell, or a solid-state organic/polymer solar cell.

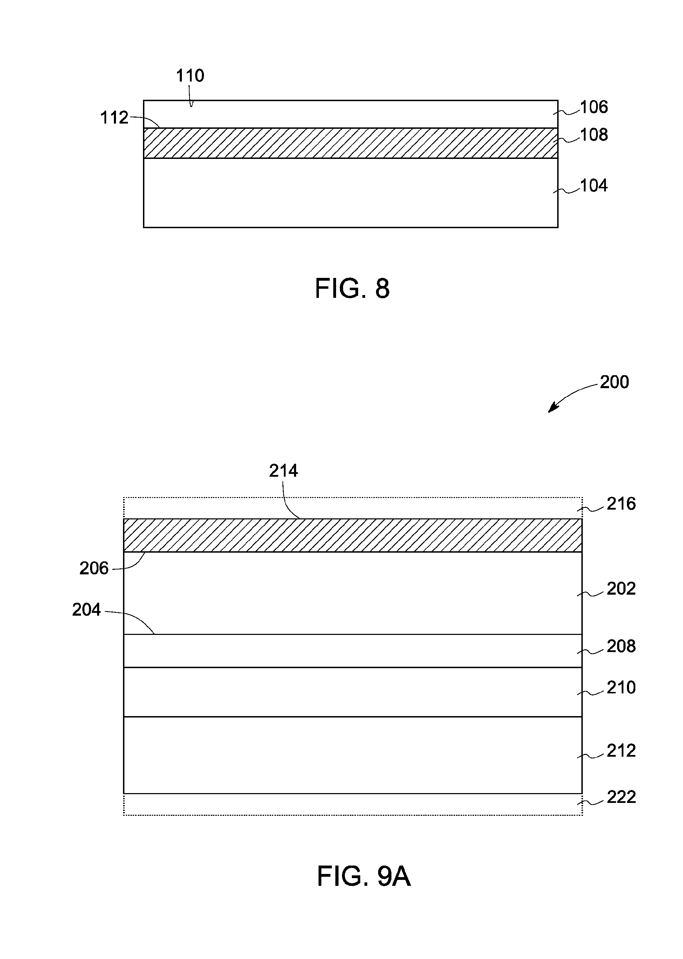

FIG. 7 illustrates one embodiment of the present invention. A photovoltaic device 102 includes a photovoltaic cell 104 and a glass plate 106 on top of the cell 104. The down-converting layer 108 is disposed on a front side of the glass plate 106. As used herein, the term "front side" of the glass plate 106 refers to a front surface 110 of the glass plate 106 that is exposed to ambient environment. In some embodiments of these types, the down-converting material for the layer 108 comprises a fluoride phosphor. A transparent dielectric layer 114 may be disposed over the down-converting layer 108 for the protection of the layer 108, in some embodiments. In alternative embodiment, the down-converting layer 108 may be disposed on a rear side of the glass plate 106 as illustrated in FIG. 8. The term "rear side" of the glass plate 106, as used herein, refers to a rear surface 112 of the glass plate 106, which is opposite to the front side and in contact with the photovoltaic cell 104. In some embodiments of these types, the down-converting layer 108 comprises an oxide phosphor.

The glass plate 106 may have a substantially planar surface. A "substantially planar surface", as defined herein, usually refers to a substantially flat surface. The surface can be smooth, although it may include a relatively minor degree (e.g., an RMS roughness that is less than about 1 micron, or more specifically less than about 300 nm) of texture, indentations, and various irregularities. These irregularities, textures, or patterns, may be useful in minimizing light trapping in the down-converting layer and channeling the converted radiation to the device by refraction at the dimpled surface.

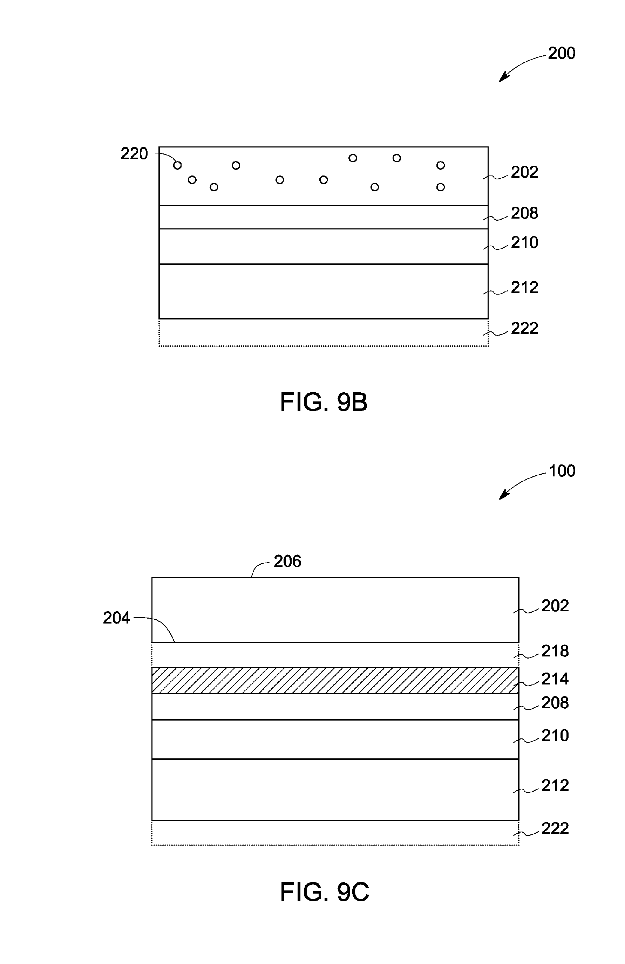

FIG. 9A, 9B, and 9C, illustrate examples of embodiments of a thin-film heterojunction PV device 200, such as a CdTe PV device or a Cu(In,Ga)Se$_2$ (CIGS) PV device. The device 200 includes a glass plate 202 having a first surface 204 and a second surface 206. The glass plate 202 acts as a substrate, in certain instances, for example in the case of a CdTe PV device. In another instance, for example in a CIGS PV device, the glass plate 202 acts as a cover and the device 200 further includes a substrate 222. Substrate selection, in these instances, may include substrates of any suitable material, including, but not limited to, metal, semiconductor, doped semiconductor, amorphous dielectrics, crystalline dielectrics, and combinations thereof.

A transparent conductive layer 208 is disposed on the first surface 204 of the glass plate. Suitable materials for transparent conductive layer 106 may include an oxide, sulfide, phosphide, telluride, or combinations thereof. These transparent conductive materials may be doped or undoped. In one embodiment, the conductive oxide may include zinc oxide, tin oxide, aluminum doped zinc oxide, fluorine-doped tin oxide, cadmium stannate (cadmium tin oxide), or zinc stannate (zinc tin oxide). In another embodiment, the conductive oxide includes indium-containing oxides. Some examples of suitable indium containing oxides are indium tin oxide (ITO), Ga-In-Sn-O, Zn-In-Sn-O, Ga-In-O, Zn-In-O, and combinations thereof. Suitable sulfides may include cadmium sulfide, indium sulfide and the like. Suitable phosphides may include indium phosphide, gallium phosphide, and the like.

A first type semiconductor layer 210 is disposed on the transparent conductive layer 208 and a second type semiconductor layer 212 is disposed on the first type semiconductor layer 210. The first type semiconductor layer 210 and the second type semiconductor layer 212 may be doped with a p-type doping or n-type doping such as to form a heterojunction. As used in this context, a heterojunction is a semiconductor junction, which is composed of layers of dissimilar semiconductor material. These materials usually have non-equal band gaps. As an example, a heterojunction can be formed by contact between a layer or region of one conductivity type with a layer or region of opposite conductivity, e.g., a "p-n" junction. In addition to solar cells, other devices, which utilize the heterojunction, include thin film transistors and bipolar transistors.

The second type semiconductor material layer 212 includes an absorber layer. The absorber layer is a part of a photovoltaic device where the conversion of electromagnetic energy of incident light (for instance, sunlight) to electron-hole pairs (that is, to electrical current), occurs. A photo-active material is typically used for forming the absorber layer. In one embodiment, the second type semiconductor material used for the absorber layer includes $Cu(In,Ga,Al)(Se,S)_2$ (also referred to as "CIGS"). In some instances, CIGS may further be substituted with an additional element, for example silver. CIGS layer or film may be manufactured by various known methods. Examples of such methods include vacuum-based processes, which co-evaporate, or co-sputter copper, gallium and indium, reactive sputtering, ion beam deposition, solution based deposition of nanoparticles precursors, and metal-organic chemical vapor deposition.

Cadmium telluride (CdTe) is another photo-active material, which may be used for the absorber layer, in one embodiment. CdTe is an efficient photo-active material that is used in thin-film photovoltaic devices. CdTe is relatively easy to deposit and therefore is considered suitable for large-scale production. A typical method to deposit CdTe is closed-space sublimation.

Quite generally, in the interest of brevity of the discussions herein, photovoltaic devices including CdTe as the photo-active material may be referred to as "CdTe PV devices" and those including CIGS may be referred to as "CIGS PV devices."

An example of the first type semiconductor 210 includes cadmium sulfide (CdS). Cadmium sulfide absorbs radiation strongly at wavelengths below about 500 nanometers and significantly reduces the quantum efficiency of a device in this wavelength region. To avoid such losses, a down-converting layer 214 is disposed on the device in front of the cadmium sulfide layer 210 that may absorb radiation with wavelength lower than about 525 nanometers and convert them to longer wavelengths, in these instances.

In one embodiment, the down-converting layer 214 may be disposed on the second surface 206 of the glass plate 202 that is exposed to ambient as shown in FIG 9A. In some instances, the layer 214 may optionally be coated with a thin dielectric layer 216. The dielectric layer 216 may include a back reflector that minimizes reflectance and assists in redirecting emitted radiation to the PV device. The back reflector, as used herein, is a substantially transparent layer and has a dielectric constant that is equal to or less than the dielectric constant of a down-converting layer. Suitable dielectric materials include silicon oxide, silicon nitride, titanium oxide, hafnium oxide, and combinations thereof.

In another embodiment, the down-converting particles 220 are dispersed within the glass plate as illustrated in FIG. 9B. In yet another embodiment as illustrated in FIG.9C, the down-converting layer 214 is disposed adjacent to the transparent conductive oxide layer, i.e. between the glass plate 202 and the transparent conducting layer 208. In some instances, a thin dielectric layer 218 optionally may be disposed between the first surface 204 of the glass plate 202 and down-converting layer 214. This dielectric layer 218 acts as a diffusion barrier for ions to enter the down-converting layer 214 and the PV cell from the glass plate 202.

Moreover, the above-mentioned photo-active semiconductor materials may be used alone or in combination. Also, these materials may be present in more than one layer, each layer having different type of photo-active material or having combinations of the materials in separate layers. One of the ordinary skills in the art would be able to optimally configure the construction and the amount of the photo-active materials to maximize the efficiency of the photovoltaic cell.

One embodiment is a photovoltaic module. The photovoltaic module may have an array of a number of the photovoltaic devices described above electrically connected in series or in parallel. Substantially all photovoltaic devices include down-converting layer disposed on the device as discussed in above embodiments. In some instances, the down-converting layer may be disposed on entire photovoltaic module. In some other embodiments, edges of the module are painted with a diffuse reflecting paint to reduce reflection and escape of emitted photon from the edge of the module.

EXAMPLES

The following examples are presented to further illustrate certain embodiments of the present invention. These examples should not be read to limit the invention in any way.

Example 1:Preparation of composite down-converting solution

Method I. Phosphor particles were formed by high temperature reaction process, followed by mechanical ball milling. Milling was continued for the time required to achieve desired particle size. These particles of desired amount were dispersed in a liquid glass precursor solution by mixing them ultrasonically.

Method II. Phosphor particle of desired size are prepared as described in method I. Prior to incorporation in the liquid glass precursor solution, the particles are subject to TEOS- based chemistry in chemical baths for deposition of various transparent oxide layer on the particle surface. These shell layers provide a graded index on the particle surface that is more effectively allow light to enter the particles for down-conversion.

Example 2

$BaAlF_5:Sm^{2+}$ particle were formed by using method I. The mean particle size of the phosphor particles is about 2 microns, and the refractive index for both particles and matrix is~1.43 with a difference of less than 0.04. These particles were dispersed in a liquid glass precursor solution. The amount of particles in the precursor solution was about 33 weight percent.

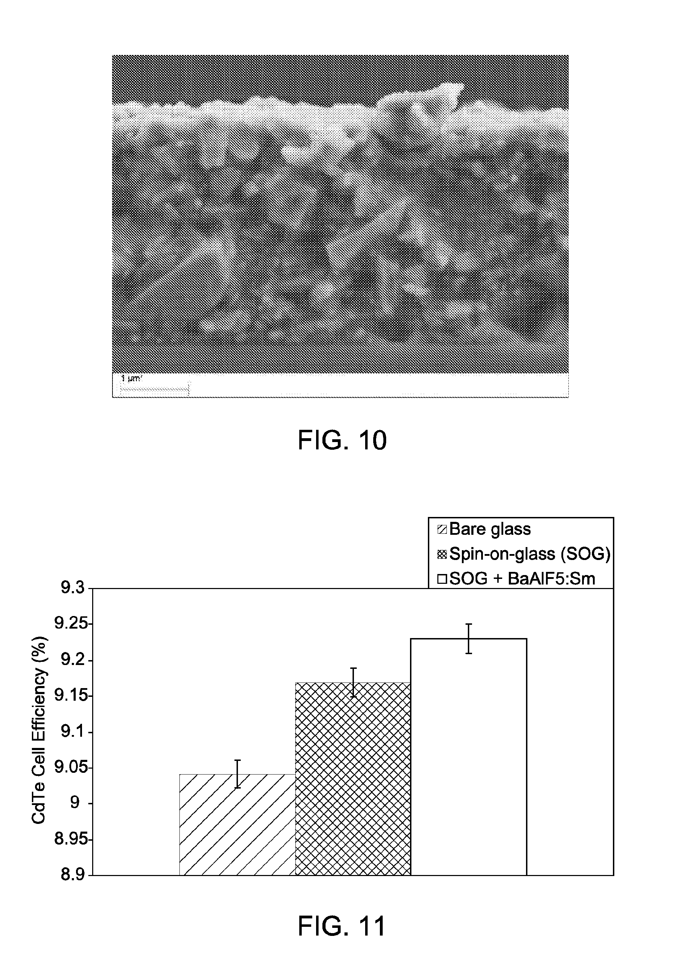

A CdTe PV module was fabricated using a standard manufacturing process on a glass substrate. At the end of manufacturing, the liquid glass precursor solution containing $BaAlF_5$: $Sm^{2+}$ particle, was applied to an outer surface of the glass by using both spin coating and spray coating techniques. The layer was then annealed at a temperature of about 80°C to form a solid glass matrix containing the $BaAlF_5$:$Sm^{2+}$ particle (composite down-converting layer). The thickness of this layer was about 3 microns. A micrograph of such a layer is shown in FIG 10. The composite layer had an effective refractive index of about 1.43 between the refractive indices of air and the underlying glass substrate. FIG. 11 shows improved efficiency of the CdTe PV module as compared to a CdTe PV module without such composite layer. The CdTe PV module having the composite down-converting layer showed an increased efficiency by 0.2 percent absolute.

Example 3

$SrB_4O_7$:$Sm^{2+}$ particles are formed by high temperature reaction process, followed by mechanical ball milling. Milling is continued until particles of average size less than about 100 nm are achieved. These particles are dispersed in a liquid glass precursor solution. The difference in refractive indices of the oxide particles and the glass is more than about 0.05 (- 1.7). Three different solutions are prepared with about 30 weight percent, about 20 weight percent, and about 10 weight percent of particles in the precursor solution. A CdTe PV module is fabricated using a standard manufacturing process. At the end of manufacturing, the solution containing the highest weight percent of particles is deposited on a glass substrate first, followed by a solution with the second high loading, and then a solution with the lowest loading to attain graded refractive index. The layers are applied using roller techniques. The layers are then annealed at a temperature of about 80°C to form a solid glass matrix containing the $SrB_4O_7$:$Sm^{2+}$ particles (composite down-converting layers). The composite layers have an effective refractive index that is decreasing respectively for about 30 weight percent, about 20 weight percent, and about 10 weight percent of particles in the precursor solution.

While only certain features of the invention have been illustrated and described herein, many modifications and changes will occur to those skilled in the art. It is, therefore, to be understood that the appended claims are intended to cover all such modifications and changes as fall within the true spirit of the invention

Various aspects and embodiments of the present invention are defined by the following numbered clauses:

1. A photovoltaic device, comprising:

   a down-converting layer disposed on the device, the down-converting layer having a graded refractive index, wherein a value of refractive index at a first surface of the down-converting layer varies from a value of refractive index at a second surface of the layer.

2. The photovoltaic device of clause 1, wherein the photovoltaic device comprises a crystalline silicon photovoltaic cell or a thin-film photovoltaic cell.

3. The photovoltaic device of clause 1, wherein the photovoltaic device comprises a single-junction cell.

4. The photovoltaic device of clause 1, wherein the photovoltaic device comprises a multi-junction cell.

5. The photovoltaic device of clause 1, wherein the photovoltaic device comprises an amorphous silicon cell, a crystalline silicon cell, a hybrid/heterojunction amorphous and crystalline silicon cell, a heterojunction thin film cell, a multiple-junction III-V-based solar cell, a dye-sensitized solar cell, or a solid-state organic/polymer solar cell.

6. The photovoltaic device of clause 1, wherein the photovoltaic device comprises a CdTe thin film cell, a micromorph tandem silicon thin film cell, a copper-zinc-tin-sulfide (CZTS) thin film cell, a metal sulfide thin film cell, a metal phosphide thin film cell, or a Cu(In,Ga,Al)(Se,S)$_2$ thin film cell.

7. The photovoltaic device of clause 1, further comprising a glass plate having a front surface, wherein the down-converting layer is disposed on the front surface of the glass plate.

8. The photovoltaic device of clause 7, further comprising a dielectric layer on the down-converting layer.

9. The photovoltaic device of clause 1, further comprising a glass plate having a rear surface, wherein the down-converting layer is disposed adjacent to the rear surface of the glass plate.

10. The photovoltaic device of clause 1, wherein the down-converting material comprises a phosphor selected from the group consisting of an oxide, a halide, and a phosphate.

11. The photovoltaic device of clause 10, wherein the down-converting phosphor comprises samarium-doped strontium borate ($SrB_4O_7$:$Sm^{2+}$), samarium-doped (Sr,Ca,Ba)BPO$_5$, europium-doped (Sr,Ca)SiO$_4$, samarium-doped $BaAlF_5$, samarium-

doped (Ba,Sr,Ca)MgF$_4$ and combinations thereof.

12. The photovoltaic device of clause 1, wherein the down-converting layer comprises multiple sub-layers.

13. The photovoltaic device of clause 12, wherein each of the sub-layer is disposed in a sequence of increasing or decreasing refractive index.

14. The photovoltaic device of clause 12, wherein the sub-layers are disposed directly one over another.

15. The photovoltaic device of clause 12, wherein the sub-layers are disposed one over another such that each of the sub-layer is separated by a dielectric layer.

16. The photovoltaic device of clause 10, wherein the down-converting layer comprises down-converting material particles dispersed in a matrix.

17. The photovoltaic device of clause 16, wherein the matrix comprises a substantially transparent material selected from the group consisting of glass, a dielectric material or a hybrid inorganic-organic material.

18. The photovoltaic device of clause 16, wherein the down-converting particles comprise particles comprising a core and a shell layer disposed on the core.

19. The photovoltaic device of clause 18, wherein the shell layer comprises a dielectric material.

20. The photovoltaic device of clause 18, wherein the shell layer comprises a plurality of layers having refractive indices that are not equal.

21. The photovoltaic device of clause 18, wherein the shell layer has less than about 10 nanometers thickness.

22. The photovoltaic device of clause 16, wherein the down-converting material is present in an amount ranging from about 1 volume percent to about 60 volume percent.

23. The photovoltaic device of clause 22, wherein the down-converting material is present in an amount ranging from about 10 volume percent to about 25 volume percent.

24. The photovoltaic device of clause 1, wherein the down-converting layer has a thickness from about 100 nanometers to about 3000 microns.

25. The photovoltaic device of clause 24, wherein the down-converting layer has a thickness from about 500 nanometers to about 1 micron.

26. The photovoltaic device of clause 24, wherein the down-converting layer has a thickness from about 1 micron to about 100 microns.

27. The photovoltaic device of clause 1, wherein the down-converting layer comprises a back reflector.

28. A photovoltaic module comprising a plurality of photovoltaic device as defined in clause 1.

**Claims**

1. A photovoltaic device, comprising:

   a down-converting layer disposed on the device, the down-converting layer having a graded refractive index, wherein a value of refractive index at a first surface of the down-converting layer varies from a value of refractive index at a second surface of the layer.

2. The photovoltaic device of claim 1, wherein the photovoltaic device comprises a crystalline silicon photovoltaic cell or a thin-film photovoltaic cell.

3. The photovoltaic device of claim 1 or claim 2, wherein the photovoltaic device comprises a single-junction cell or a multi-junction cell.

4. The photovoltaic device of any preceding claim, wherein the photovoltaic device comprises an amorphous silicon cell, a crystalline silicon cell, a hybrid/heterojunction amorphous and crystalline silicon cell, a heterojunction thin film cell, a multiple-junction III-V-based solar cell, a dye-sensitized solar cell, or a solid-state organic/polymer solar cell.

5. The photovoltaic device of any one of claims 1 to 3, wherein the photovoltaic device comprises a CdTe thin film cell, a micromorph tandem silicon thin film cell, a copper-zinc-tin-sulfide (CZTS) thin film cell, a metal sulfide thin film cell, a metal phosphide thin film cell, or a Cu(In,Ga,Al)(Se,S)$_2$ thin film cell.

6. The photovoltaic device of any preceding claim, further comprising a glass plate having a front surface, wherein the down-converting layer is disposed on the front surface of the glass plate.

7. The photovoltaic device of claim 6, further comprising a dielectric layer on the down-converting layer.

8. The photovoltaic device of any one of claims 1 to 5, further comprising a glass plate having a rear surface, wherein the down-converting layer is disposed adjacent to the rear surface of the glass plate.

9. The photovoltaic device of any preceding claim, wherein the down-converting material comprises a phosphor selected from the group consisting of an oxide, a halide, and a phosphate.

10. The photovoltaic device of claim 9, wherein the down-converting phosphor comprises samarium-doped strontium borate ($SrB_4O_7:Sm^{2+}$), samarium-doped $(Sr,Ca,Ba)BPO_5$, europium-doped $(Sr,Ca)SiO_4$, samarium-doped $BaAlF_5$, samarium-doped $(Ba,Sr,Ca)MgF_4$ and combinations thereof.

11. The photovoltaic device of claim 1, wherein the down-converting layer comprises multiple sub-layers which are disposed in a sequence of increasing or decreasing refractive index.

12. The photovoltaic device of claim 9, wherein the down-converting layer comprises down-converting material particles dispersed in a matrix.

13. The photovoltaic device of claim 12, wherein the down-converting particles comprise particles comprising a core and a shell layer disposed on the core.

14. The photovoltaic device of any preceding claim, wherein the down-converting layer has a thickness from about 100 nanometers to about 3000 microns.

15. A photovoltaic module comprising a plurality of photovoltaic devices as defined any preceding in claim.

FIG. 1

FIG. 2

FIG. 3

FIG. 4

FIG. 5

FIG. 6

FIG. 7

## FIG. 8

## FIG. 9A

200

220

202

208

210

212

222

FIG. 9B

100

206

204

202

218

214

208

210

212

222

FIG. 9C

FIG. 10

FIG. 11